(19) Europäisches Patentamt
European Patent Office
Office européen des brevets

(11) **EP 2 258 045 B1**

(12) **EUROPEAN PATENT SPECIFICATION**

(45) Date of publication and mention
of the grant of the patent:
**12.02.2014 Bulletin 2014/07**

(21) Application number: **09723662.4**

(22) Date of filing: **19.03.2009**

(51) Int Cl.:
*H03F 1/34* (2006.01)   *H03F 3/189* (2006.01)
*H03F 3/24* (2006.01)   *H03G 3/30* (2006.01)
*H04B 1/04* (2006.01)

(86) International application number:
**PCT/US2009/037676**

(87) International publication number:
**WO 2009/120577 (01.10.2009 Gazette 2009/40)**

(54) **RF TRANSMITTER AND METHOD OF OPERATION**

HF-SENDER UND BETRIEBSVERFAHREN DAFÜR

ÉMETTEUR RF ET PROCÉDÉ D'EXPLOITATION

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **27.03.2008 GB 0805566**

(43) Date of publication of application:
**08.12.2010 Bulletin 2010/49**

(73) Proprietor: **Motorola Solutions, Inc.
Schaumburg IL 60196 (US)**

(72) Inventors:
• **BEN-AYUN, Moshe
73142 Shoham (IL)**
• **GROSSMAN, Ovadia
62497 Tel Aviv-Yaffo (IL)**
• **ROZENTAL, Mark
70700 Gedera (IL)**
• **VALLACH, Uri
49379 Petach-Tikva (IL)**

(74) Representative: **Treleven, Colin et al
Optimus Patents Limited
Grove House
Lutyens Close
Basingstoke
Hampshire, RG24 8AG (GB)**

(56) References cited:
**GB-A- 2 287 371**

**Description**

TECHNICAL FIELD

The technical field relates to a radio frequency (RF) transmitter and a method of operation of the transmitter. In particular, the technical field relates to an RF transmitter including a linearity control loop and a method of operation of level training in the transmitter.

BACKGROUND

RF communication terminals normally employ an RF transmitter to generate RF signals, a receiver to receive RF signals and an antenna to send radiated signals produced by the transmitter over-the-air to another terminal and to receive signals sent over-the-air from another terminal for delivery to the receiver. The transmitter normally includes an RF power amplifier, 'RFPA', to amplify the RF signals before they are delivered to the antenna for transmission.

It is desirable for the RF transmitter to be linear, i.e. for the RFPA to produce a power amplification which is a linear function of the power of the input signal provided to it, in order to prevent distortion of the input signal and to minimize adjacent channel interference. Many RF transmitters include at least one control loop such as a Cartesian loop to provide linearization of the RFPA of the transmitter.

The control loop may be operated in a training mode to set a suitable strength level (of the baseband signal delivered along the forward path) which in operation does not cause compression of the RFPA.

The control loop may include a loop filter which may include one or more filter stages. One purpose of the loop filter is to constrain the bandwidth of the loop to ensure stability of the loop. In filter analysis, it well known to define such a filter in terms of the transfer function of the filter, especially parameters known as the poles and zeros which are obtained from the transfer function of the filter. For example, the transfer function $H(s)$ of an LTI filter used as a loop filter may be defined as $H(s) = Y(s) / X(s)$ where the terms $Y(s)$ and $X(s)$ are polynomial expressions which can be factorised; the multiplying factors of the factorised expressions can be written in the form, $s-q_i$ where i is an integer, 1,2,3.. The (possibly complex) numbers $q_i$ are the roots of the polynomial. When $s$ is set to the value of any of these roots of the numerator polynomial term $Y(s)$ which results in the transfer function evaluating to zero, the root in question is denoted as a 'zero'. When s is set to the value of any of the roots of the denominator polynomial term $X(s)$ which results in the transfer function approaching infinity, the root in question is denoted as a 'pole'. The concept of zeros and poles will of course be familiar to those skilled in the art of designing filters.

The loop filter used in a control loop such as a Cartesian loop in a linear RF transmitter is normally designed to have a first pole at a low frequency and a second pole and a zero at higher frequencies. The precise positions in frequency of the first pole, the second pole and the zero are selected according to the properties of the RF signal that has to be transmitted by the transmitter. In some transmitters, the selection of these positions can lead to a serious problem during level training described above. The loop filter may no longer be a perfect integrator and this can cause difficulty in identifying during level training the appropriate strength level needed to avoid compression of the RFPA.

Thus, there exists a need for a linear RF transmitter, for use in mobile communications, which addresses at least some of the shortcomings of past and present techniques and/or procedures employed for level training in such transmitters.

GB-A-2287371 (Motorola), concerns training of linear power amplifiers. Line 37 on page 1 to line 2 on page 2 of GB'371 specifies: *...the maximum limit of training is set in the calibration mode. The maximum limit is set at a level known to be below the clip point. Thereafter, training signals are not allowed to exceed that level.'*

BRIEF DESCRIPTION OF THE ACCOMPANYING DRAWINGS

The accompanying drawings, in which like reference numerals refer to identical or functionally similar items throughout the separate views which, together with the detailed description below, are incorporated in and form part of this patent specification and serve to further illustrate various embodiments of concepts that include the claimed invention, and to explain various principles and advantages of those embodiments.

In the accompanying drawings:

FIG. 1 is a block schematic diagram of an illustrative RF transmitter.

FIG. 2 is a graph of a level plotted against time of an input test signal used in the transmitter of FIG. 1, illustrating a suitable waveform of the test signal.

FIG. 3 is graph of a level plotted against time of a combined signal produced by a combiner of a forward path of the transmitter of FIG. 1, the graph illustrating a suitable response of the combined signal to application of the test signal illustrated in FIG. 2.

FIG. 4 is a flow chart of an illustrative method of operation of the RF transmitter of FIG. 1.

Skilled artisans will appreciate that items shown in the drawings are illustrated for simplicity and clarity and have not necessarily been drawn to scale. For example, the dimensions of some of the items may be exaggerated relative to other items to assist understanding of various embodiments. In addition, the description and drawings do not necessarily require the order illustrated. Apparatus and method components have been represented where appropriate by conventional symbols in the drawings, showing only those specific details that are pertinent to understanding the various embodiments so as not to obscure the disclosure with details that will be readily apparent to those of ordinary skill in the art having the benefit of the description herein. Thus, it will be appreciated that for simplicity and clarity of illustration, common and well-understood items that are useful or necessary in a commercially feasible embodiment may not be depicted in order to facilitate a less obstructed view of these various embodiments.

DETAILED DESCRIPTION

Generally speaking, pursuant to the various embodiments to be described, there is provided a linear RF transmitter including a forward path for receiving and processing in an operational mode an input baseband signal and for producing a modulated RF signal from the baseband signal, the forward path including a baseband signal combiner and an RF (radio frequency) power amplifier, a linearizing control loop including a coupling from an output of the RF power amplifier to an input of the combiner, wherein the control loop includes a feedback control path operable to deliver a baseband error control signal to the combiner, the transmitter further including a test signal generator operable to apply to the combiner in a closed loop level training mode a test signal comprising a voltage $V_{in}$ which increases with time in a non-linear manner approaching an asymptotic limit such that in response an output signal produced by the combiner is a voltage $V_e$ which is substantially constant over a period of time.

The voltage $V_{in}$ may vary with time $t$ according to an inverse exponential relationship. As demonstrated later, the relationship may be defined as: $V_{in}(t) = k\beta A[1 - e^{-\frac{t}{\tau 1}}]$ where $e$ represents an exponential, $\tau 1$ represents

a time constant of the first filter pole of the control loop, $k$ represents a constant and $\beta A$ represents a loop gain of the control loop, 'A' being the gain of the loop in the forward path and '$\beta$' being the gain of the loop in the feedback path.

Applying the test signal in the non-linear form of $V_{in}$ as defined above allows the voltage $V_e$ developed in response at the output of the combiner, e.g. between the combiner and a loop low pass filter, to be substantially constant over a period of time.

Eventually, the test signal reaches a level at which the RFPA of the transmitter is driven into a condition of compression. At this level, the voltage $V_e$ begins to rise rapidly with time. Detection of this level of the test signal allows the onset of compression to be detected. By ensuring that the voltage $V_e$ is substantially constant in the period of time prior to the onset of compression in the level training mode, the onset of compression in that mode may be detected more accurately than in the prior art, thereby avoiding the possibility of a false detection of compression of the RFPA.

Furthermore, applying the test signal in the non-linear form of $V_{in}$ as defined above allows the voltage $V_e$ developed in response to remain substantially constant even when the control loop includes a low pass filter having a first filter pole at a frequency which is substantially higher than zero Hertz, e.g. at least 1 kHz. Such a control loop may suitably be employed in a transmitter for transmitting a signal having a wideband modulation, e.g. a modulation band wider than 25 kHz, such as a signal in accordance with the TETRA 2 standard, the HPD (High Performance Data) protocol, the HSD (High Speed Data) protocol or the WiMax protocol.

Those skilled in the art will appreciate that these recognized benefits and advantages and other advantages described herein are merely illustrative and are not meant to be a complete rendering of all of the benefits and advantages of the various embodiments of the invention.

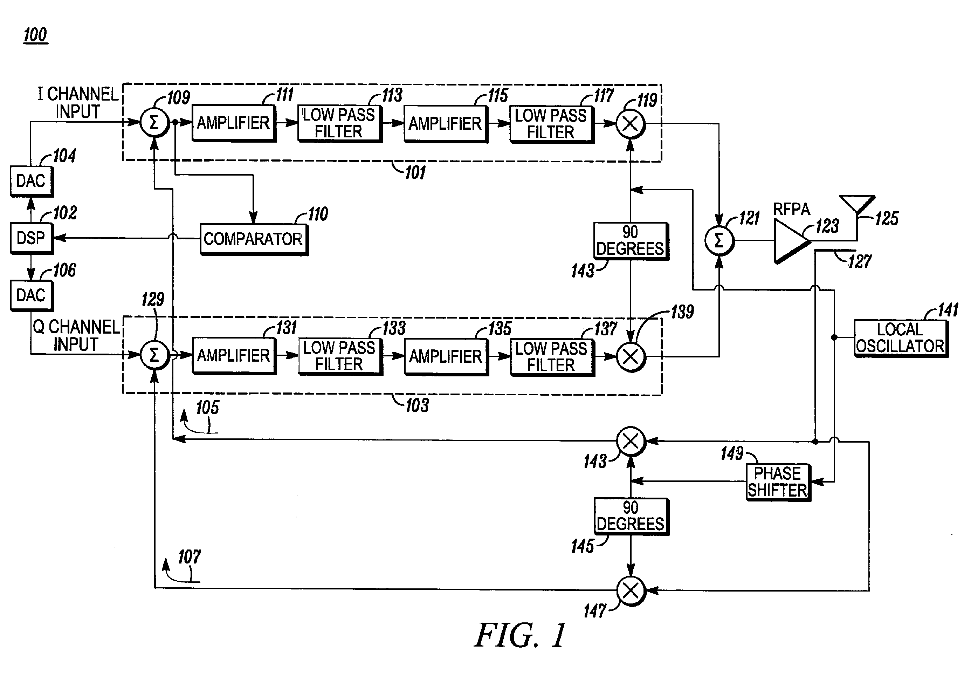

Referring now to the accompanying drawings, and in particular to FIG. 1, there is shown a block schematic diagram of an illustrative RF transmitter 100. The transmitter 100 includes a Digital Signal Processor (DSP) 102 coupled to a Digital to Analog Converter (DAC) 104 and a Digital to Analog Converter (DAC) 106. The DSP 102 serves as a generator of a baseband signal in an operational mode and a generator of a test signal in a training mode. The DSP 102 is thus an illustration of the 'test signal generator' referred to herein. In an operational mode, the DSP 102 produces a baseband digital output 'I' signal component which is converted into analog form by the DAC 104. The DSP 102 also produces a baseband digital output 'Q' signal component which is converted into analog form by the DAC 106.

An output signal produced by the DAC 104 is delivered as a baseband I channel input signal to an I (In-phase) channel 101 of a forward signal delivery path which extends eventually to an antenna 125. An output signal produced by the DAC 106 is delivered as a baseband Q channel input signal to a Q (Quadrature phase) channel 103 of the forward path.

The I channel 101 includes a combiner 109 which may be a differential summer. The combiner 109 is a baseband signal combiner which receives as a first input signal the I channel input signal from the DAC 104. The combiner 109 also receives as a second input signal an error control signal from an I feedback control channel 105. The combiner 109 produces an output signal which is a differential sum of (difference between) its first and second input signals. The output signal produced by the combiner 109 is applied in turn to an amplifier 111, a low pass filter 113, a further amplifier 115 and a further low pass filter 117. The amplifiers 111 and 115 provide optional gain stages in the I channel 101. The low pass filter 113 sets a first filter pole of a complete negative feedback control loop which includes the I feedback control channel 105. The control loop is described in more detail later. The low pass filter 117 sets a second filter pole and a zero of the complete control loop.

The Q channel 103 includes a combiner 129 which may be a differential summer 129. The combiner 129 is a baseband signal combiner which receives as a first input signal the Q channel input signal from the DAC 106. The combiner 129 also receives as a second input signal an error control signal from a feedback control channel 107. The combiner 129 produces an output signal which is a differential sum of its first and second input signals. The output signal produced by the combiner 129 is applied in turn to an amplifier 131, a low pass filter 133, a further amplifier 135 and a further low pass filter 137.

The amplifiers 131 and 135 provide optional gain stages in the Q channel 103. The low pass filter 133 sets a first filter pole of a complete negative feedback control loop which includes the feedback control channel 107. The control loop is described in more detail later. The low pass filter 137 sets a second filter pole and a zero of the complete control loop. Either or both of the low pass filters 137 and 117 may be programmable.

The first pole, the second pole and the zero of the control loops that include the feedback control channels 105 and 107 may have the same respective values in the two loops including, respectively, the I channel 101 and the Q channel 103.

The first filter pole of each loop may be set at a frequency of at least 1 kHz, e.g. at a frequency of about 3 kHz, to suit wideband modulation operation of the transmitter 100. The same first filter pole setting may be used for different applications of the transmitter 100, e.g. for use of the transmitter 100 alternatively in a TETRA 1 system or terminal and in a TETRA 2 system or terminal as defined later.

The second filter pole and zero may be at frequency settings which depend on the particular application and implementation of the transmitter 100. The settings may be at different frequencies for different applications of the transmitter 100. Illustratively, the second pole may set at a frequency of about 25 kHz for use in a TETRA 1 system and at a frequency of about 108 kHz for use in a TETRA 2 system. Illustratively, the zero may be set to be at a frequency of about 250 kHz for use in a TETRA 1 system and a frequency of about 1 MHz for use in a TETRA 2 system.

A mixer 119 in the I channel 101 receives a baseband signal produced by the low pass filter 117. The mixer 119 upconverts the baseband signal to an RF carrier frequency by mixing the baseband signal with a carrier frequency signal applied to the mixer 119. The carrier frequency signal is produced by a local oscillator 141.

Similarly, a mixer 139 in the Q channel 103 receives an output baseband signal produced by the low pass filter 137. The mixer 139 converts the baseband signal to an RF carrier frequency by mixing the baseband signal with a carrier frequency signal applied to the mixer 139. The carrier frequency signal is a signal produced by the local oscillator 141 and delivered to the mixer 139 via a phase shifter 143 which shifts the phase of the signal by ninety degrees.

The mixer 119 and the mixer 139 respectively produce RF output signals which are applied as input signals to a summer 121. The summer 121 adds the input component signals applied to it to produce a combined RF output signal which is applied to an RF power amplifier (RFPA) 123 and is amplified by the RFPA 123. An amplified output signal produced by RFPA 123 is delivered to the antenna 125 for sending by wireless communication to at least one remote receiver (not shown).

The transmitter 100 may be part of a transceiver which includes a receiver (not shown). In that case, an antenna switch or duplexer or the like (not shown) may be located between the RFPA 123 and the antenna 125 to allow the RFPA 123 to be isolated from the antenna 125 and the receiver when the antenna 125 and the receiver are operating together in a receiving mode.

A coupler 127, e.g. a directional coupler, at an output of the RFPA 123 serves as a sampler to sample the amplified RF output signal produced by the RFPA 123. The sampled RF signal is applied as a first input signal to a mixer 143 in the I feedback control channel 105 and as a first input signal to a mixer 147 in the Q feedback control channel 147. The mixer 143 also receives a second input which is the signal produced by the local oscillator 141 via a phase shifter 149. The mixer 147 also receives a second input signal which is the signal produced by the local oscillator 141 delivered to the mixer 147 via the phase shifter 149 and a phase shifter 145. The phase shifter 145 shifts the phase of the signal applied to it by ninety degrees. The phase shifter 149 applies adjusting shifts to the phase of the signal from the local oscillator 141 when required during a phase training mode of the transmitter 100 as described in more detail later.

The mixer 143 produces, by downconverting the frequency of the RF signal applied to it, a baseband I error control signal which is applied to the combiner 109. Similarly, the mixer 147 produces, by downconverting the frequency of the RF signal applied to it, a baseband Q error signal which is applied to the combiner 129. As mentioned earlier, the error control signals applied respectively to the combiner 109 and the combiner 129 are differentially added to (subtracted from) the I channel input signal and the Q channel input signal, respectively.

Thus, the linearizing control loop (Cartesian loop) of the transmitter 100 comprises: the 'I' loop extending from the combiner 109 via the I channel 101 to the coupler 127 and from the coupler 127 via the I feedback control channel 105 to the combiner 109; and the 'Q' loop extending from the combiner 129 via the Q channel 103 to the coupler 127 and from the coupler 127 via the Q feedback control channel 107 to the combiner 129. The feedback control path of the control loop comprises: the part of the 'I' loop extending from the coupler 127 via the I feedback control channel 105 to the combiner 109; and the part of the 'Q' loop extending from the coupler 127 via the Q feedback control channel 107 to the combiner 129.

As will be apparent to those skilled in the art, the I feedback control channel 105 and the Q feedback control channel 107 may each include one or more filters (not shown) and one or more amplifiers (not shown).

The transmitter 100 has an operational mode in which the transmitter 100 generates and sends RF signals in a usual manner. The transmitter 100 also has at least one training mode including a level training mode. The transmitter 100 may also include a phase training mode. The training mode(s) may be applied at selected times, e.g. at regular intervals between periods when the operational mode is applied. The intervals employed for the training mode(s) may be those defined in a protocol according to which the transmitter is operating. For example, where the transmitter 100 operates according to the TETRA 1 standard, the intervals may correspond to time slots of the TETRA timing protocol which are set aside for transmitter linearizing purposes, namely slots known as the Common Linearisation Channel (CLCH).

During each operation of the level training mode, the control loop comprising: (i) the I channel 101 of the forward path and the I feedback control channel 105; and (ii) the Q channel 103 of the forward path and the feedback control channel 107; operates in a closed loop mode. The DSP 102 generates a test signal which is applied to either or both of the I channel 101 and the Q channel 103. The purpose of applying the test signal in the level training mode is to detect a compression point or condition of the RFPA 123 when the operation of the RFPA 123 (in terms of its output power as a function of its input power) becomes non-linear.

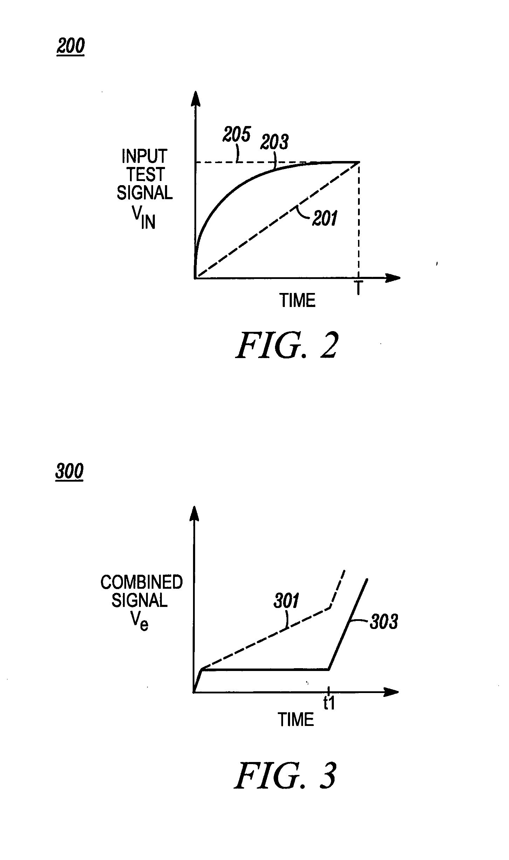

FIG. 2 is a graph 200 showing a plot 203 in which a level of the input test signal when applied to the combiner 109 or the combiner 129 or both is plotted against time. This input signal is referred to herein as a signal $V_{in}$. The signal $V_{in}$ comprises a voltage waveform. The plot 203 which describes the applied voltage waveform of the input test signal $V_{in}$ has a shape which is curved rather than straight as indicated for comparison purposes by a dashed straight line 201 representing a conventional test signal. The plot 203 has an inverse exponential form explained in more detail later. As the level of the test signal $V_{in}$ in the plot 203 increases, the level approaches an asymptotic limit indicated by a dashed horizontal line 205. The level of the test signal $V_{in}$ reaches a practical maximum at a time T. The shape of the plot 203 is selected so that a desired combined signal $V_e$ developed in response at the output of the combiner 109 and/or at the output of the combiner 129 (depending on where $V_{in}$ is applied) is substantially constant with time.

FIG. 3 is a graph 300 of the combined signal $V_e$ plotted against time showing a plot 303 which represents the desired form of the combined signal $V_e$. The combined signal $V_e$ is another voltage waveform. The plot 303 has, until a time t1, a substantially horizontal portion in which the level of the combined signal $V_e$ is substantially constant with time. When the input test signal $V_{in}$ reaches a particular level at the time t1, the compression point of the RFPA 123 is reached causing the combined signal $V_e$ indicated by the plot 303 to increase steeply with time.

For comparison purposes, FIG. 3 also shows a dashed plot 301 which corresponds to the combined signal obtained using an input test signal having the conventional straight line form indicated by the line 201 in FIG. 2. Although the plot 301 has an increase in gradient at the time t1, the plot 301 undesirably shows an increase with time throughout the duration of the input test signal making detection of the compression point inaccurate. Such detection can be made in error before the RFPA 123 is driven into compression.

The combined signal $V_e$, as represented by the plot 303, produced by the combiner 109 or by the combiner 129 or both, is monitored by a detector to detect a point on the plot 303 when the plot 303 begins to rise steeply at the time t1 indicating that the RFPA 123 compression point has been reached. For example, as shown in FIG. 1, the combined signal $V_e$ when produced by the combiner 109 may be applied to a comparator 110 in which it is compared with a reference signal. The level of the reference signal may be selected to be equivalent to an instant in time when the RFPA 123 reaches a specified point of compression on its power transfer characteristic. The level selected will depend on the particular implementation conditions employed. An illustrative value of the level is for example about 90 mV for a transmitter of a TETRA mobile terminal.

The comparator 110 produces an output indication signal when the level of the combined signal $V_e$ reaches the level of the reference signal. The output indication signal is applied to the DSP 102. The DSP 102 correlates the instant of time when the output indication signal is produced by the comparator 110 with a particular level of the input test signal $V_{in}$ which was provided by the DSP 102 and which caused the production of the output indication signal. The DSP 102 is able therefore to detect a corresponding level of the input test signal $V_{in}$ at which the RFPA 123 is driven into compression. In response, the DSP 102 sets a level (amplitude) for output baseband signals to be produced by the DSP 102 in the next period of the operational mode. The level is chosen to be a suitable margin below the level detected to cause compression of the RFPA 123.

As known in the art, the transmitter 100 may have a phase training mode which may conveniently be applied prior to the level training mode, e.g. in the same training interval in which each application of the level training mode is made. In the phase training mode, the control loop including the feedback control channels 105 and 107 is operated in an open loop mode to determine in a known manner a correct phase for stable operation of the control loop. The result of phase training is programmed to the phase shifter 149 to apply a suitable phase shift. The phase shift so set is applied in the next period of the operational mode with the control loop operating in closed loop mode.

An illustrative analysis of the transmitter 100 which supports the use of the input test signal $V_{in}$ having the form of the plot 203 shown in FIG. 2 is as follows.

For ideal application of the level training mode, the first filter pole of the control loop comprising the I feedback control channel 105 and the I channel 101 of the forward path and/or the Q feedback channel 107 and the Q channel 103 of the forward path is at a frequency of zero so that the first pole acts properly as an integrator. However, when the first filter pole of the control loop is at a frequency significantly greater than zero, such as at an illustrative frequency of at least 1 kHz, e.g. at a frequency of 3 kHz as produced by the low pass filters 113 and 133, the first pole is no longer an integrator.

The combined signal $V_e$ provides (after amplification by the amplifier 111 or the amplifier 133 as appropriate) an input to the filter providing the first pole of the control loop, i.e. the low pass filter 113 or the low pass filter 133 as appropriate. The combined signal $V_e$ provides a suitable baseband signal to monitor to detect compression of the RFPA 123. The combined signal $V_e$ is related to the input test signal $V_{in}$ applied in the appropriate forward channel, e.g. the I channel 101, by the relationship:

$$Ve = Vin * \frac{1}{\beta A} \qquad \text{(Equation 1)}$$

where $\beta A$ is the Cartesian feedback loop gain.

Where the first loop filter pole is a perfect integrator, applying $V_{in}$ in the form of a straight line ramp, as indicated by the line 201 in FIG. 2, will produce in response a form of the combined signal $V_e$ which does not increase with time during the linear operation of the RFPA 123, i.e. before the compression point of the RFPA 123.

However, where the first pole is not a perfect integrator, for example at a frequency of at least 1 kHz, such as a frequency of about 3 kHz, then applying $Vin$ in the form of a straight line ramp, as indicated by the line 201 in FIG. 2, will produce a form of $Ve$ which is not constant. By assuming that the first loop filter pole is dominant and the second loop filter pole and zero can be neglected, it can be shown that $V_e(t)$ and time t have the approximate relationship:

$$V_e(t) \approx \frac{a}{\beta A} t \qquad (2)$$

In other words, where the first pole is not a perfect integrator and $V_{in}$ is applied in the form of a straight line ramp, $V_e(t)$ is rising as a function of time as illustrated by the plot 301 shown in FIG. 3, where $a$ is a constant (the angle of the lower part of the plot 301 relative to the horizontal time axis). It has been found that this form of $V_e(t)$ can lead to errors in detection of the compression point of the RFPA 123.

In order to calculate $V_{in}$ as a function of time, i.e. $V_{in}(t)$, so that $V_e(t)$ remains constant, the Laplace transform $V_e(s)$ of $V_e(t)$ may be considered. The Laplace transform $V_e(s)$ is given by:

$$V_e(s) = \frac{k}{s} = \frac{\tau 1}{\beta A} \left[ s + \frac{1}{\tau 1} \right] V_{in}(s) \qquad \text{(Equation 3)}$$

where $V_{in}(s)$ is the Laplace transform of $V_{in}(t)$. Rearranging Equation 3 gives:

$$V_{in}(s) = \frac{k\beta A}{\tau 1}\left[\frac{1}{s + \frac{1}{\tau 1}}\right]\frac{1}{s} = G(s)\frac{1}{s} \qquad \text{(Equation 4)}$$

where

$$G(s) = \frac{k\beta A}{\tau 1}\left[\frac{1}{s + \frac{1}{\tau 1}}\right] \qquad \text{(Equation 5)}$$

$k$ is a constant and $\beta A$ and $\tau 1$ are as defined earlier. The inverse Laplace transform of $G(s)$, $G(t)$, can be obtained as follows. Using the property of Laplace transformation, if $V_{in}(s) = G(s)\dfrac{1}{s}$ then:

$$V_{in}(t) = \int_0^t G(t)dt \qquad \text{(Equation 6)}$$

Inverse Laplace transformation of $G(s)$ defined in Equation 5 thus allows $G(t)$ to be obtained as follows:

$$G(t) = \frac{k\beta A}{\tau 1}e^{-\frac{t}{\tau 1}} \qquad \text{(Equation 7)}$$

Thus, substituting the value of $G(t)$ given in Equation 7 into Equation 6 gives:

$$V_{in}(t) = \frac{k\beta A}{\tau 1}\int_0^t e^{-\frac{t}{\tau 1}}dt = k\beta A[1 - e^{-\frac{t}{\tau 1}}] \qquad \text{(Equation 8)}$$

Thus, the function defined by Equation 8 represents the form of the voltage waveform required for the test signal $V_{in}(t)$ to produce a constant value of the combined voltage $V_e$ until the RFPA 123 is driven into compression.

The maximum value $V_{in\_max}$ of the applied waveform of the test signal $V_{in}(t)$ should be high enough to drive the RFPA 123 into compression during the level training mode. $V_{in\_max}$ is given by:

$$V_{in\_\max} = k\beta A = \beta V_{out\_\max} \qquad \text{(Equation 9)}$$

where $V_{out\_max}$ is the maximum RMS level in Volts of the signal produced by the RFPA 123. For a TETRA transmitter, the output power needs to reach 6 Watts during level training as specified by the TETRA standard. This is equivalent to an RMS value of $V_{out\_max}$ of about 17 Volts. In addition, in an illustrative example, $\beta$=-50$dB$=1/316, $k$ is 30 millivolts and A is 67 dB. Using these values gives an illustrative maximum value $V_{in\_max}$ of the applied waveform $V_{in}(t)$ of about 0.22 Volt. Thus, the maximum level of $V_{in}(t)$ when of the form illustrated by plot 203 may be selected to be a suitable value, e.g. in a range between about 0.1 Volt and about 1.0 Volt, especially between about 0.1 Volt and 0.5 Volt.

A suitable value of the required duration of the applied waveform $V_{in}(t)$ having the form of the plot 203 in FIG. 3 may be a duration in the range of from about 100 microseconds to about 300 microseconds. An illustrative calculation of the duration is as follows. It is known that for an exponential function having the form defined by Equation 8, the exponential function reaches 95 per cent of its final value (the asymptote 205) when the time has reached a value $t=3\tau1$. Thus, the duration may be set as a suitable time longer (e.g. at least 105 per cent longer) than $t=3\tau1$. As noted earlier, if for example the first filter pole of the control loop has a frequency of 3 kHz, then $t=3\tau1$ has a value of about 159 microseconds. So, for the case where the first pole has a frequency of 3 kHz, the duration of the waveform of the test signal $V_{in}(t)$ may be a suitable time not less than about 165 microseconds. Typically, the duration may be selected to be a time of between about 100 microseconds and about 300 microseconds, such as a time of about 200 microseconds.

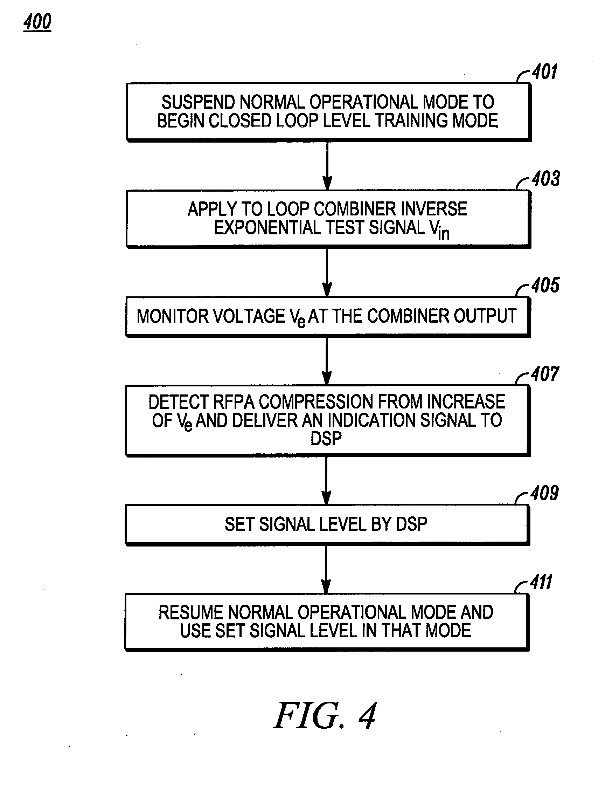

FIG. 4 is a flow chart of a method 400 which summarises operation of the transmitter 100 in the embodiments described above.

At 401 of the method 400, a normal operational mode of the transmitter 100 is suspended and a closed loop training mode is begun. This may be at the start of an interval set aside for the training mode. For example where the transmitter 100 is a TETRA transmitter, the interval may be a time frame set aside for such training as defined by the TETRA standard.

At 403, a test signal generated by the DSP 102 is applied as an I channel input signal to the combiner 109 and/or as a Q channel input signal to the combiner 129. The test signal is a voltage waveform $V_{in}$ having the inverse exponential form represented by Equation 8 given earlier.

At 405 which is carried out in conjunction with 403, a voltage $V_e$ developed at the output of the combiner 109 and/or the combiner 129 as appropriate is monitored. The voltage $V_e$ has, as a function of time, the form of the plot 303 shown in FIG. 3.

At 407, compression of the RFPA 123 is detected, e.g. by the comparator 110, from an increase in $V_e$, and an indication signal is sent to the DSP 102.

In response to receiving the indication signal, the DSP 102 determines the voltage level of $V_{in}$ at which the RFPA 123 was driven into compression and accordingly, at 409, sets a signal level for baseband signals generated by the DSP 102 to avoid compression of the RFPA 123. The DSP 102 may use the time indicated by the delivered signal, i.e. the time of issue of the delivered signal, to identify a point in time on the test signal comprising the voltage waveform $V_{in}$ when the signal level is at suitable level for selection.

Finally, the normal operational mode of the transmitter 100 is resumed at 411, and the DSP 102 uses the signal level set in the level training mode for signals produced by the DSP 102 in the normal operational mode.

The transmitter 100 and the method 400 are suitable for use in: (i) in a narrow band communication terminal such as a terminal operating according to the basic TETRA (TETRA 1) standard defined by the European Telecommunications Standards Institute, in which the transmitted signal will have a relatively narrow 25 kHz modulation bandwidth; the first pole of the loop filter may be selected accordingly to be at or near to a frequency of zero Hertz; and also in: a communication terminal having a wider modulation band, e.g. in a TETRA 2 terminal operating according to the TETRA 2 (TETRA Enhanced Data Services) standard defined by ETSI having a modulation bandwidth of up to 150 kHz; the position of the loop filter first pole in such a terminal is desirably shifted to a higher frequency, e.g. a frequency of at least 1 kHz, e.g. about 3 kHz. The transmitter 100 may be a dual- or multi-mode transmitter which operates in different selected modes (e.g. TETRA 1 and TETRA 2) in the same terminal.

In the foregoing specification, specific embodiments have been described. However, one of ordinary skill in the art will appreciate that various modifications and changes can be made without departing from the scope of the invention as set forth in the accompanying claims. Accordingly, the specification and drawings are to be regarded in an illustrative rather than a restrictive sense, and all such modifications are intended to be included within the scope of present teachings. The benefits, advantages, solutions to problems, and any element(s) that may cause any benefit, advantage, or solution to occur or become more pronounced are not to be construed as critical, required, or essential features or elements of any or all the claims. The invention is defined solely by the appended claims including any amendments made during the pendency of this patent application and all equivalents of those claims as issued.

Moreover in this document, relational terms such as 'first' and 'second', 'top' and 'bottom', and the like, may be used solely to distinguish one entity or action from another entity or action without necessarily requiring or implying any actual such relationship or order between such entities or actions. The terms 'comprises', 'comprising', 'has', 'having', 'includes', 'including', 'contains', 'containing' or any other variation thereof, are intended to cover a non-exclusive inclusion, such that a process, method, article, or apparatus that comprises, has, includes or contains a list of elements does not include only those elements but may include other elements not expressly listed or inherent to such process, method, article, or apparatus. An element preceded by 'comprises ...a', 'has ...a', 'includes ...a', or 'contains ...a' does not, without more constraints, preclude the existence of additional identical elements in the process, method, article, or apparatus that comprises, has, includes, contains the element. The terms 'a' and 'an' are defined as one or more unless explicitly stated otherwise herein.

The terms 'substantially', 'essentially', 'approximately', 'about' or any other version thereof, are defined as being close to as understood by one of ordinary skill in the art, and in one non-limiting embodiment the term is defined to be within 10%, in another embodiment within 5%, in another embodiment within 1% and in another embodiment within 0.5%, of a stated value. It is to be noted that these expressions may be used herein to indicate that a value obtained in practice may be different from a nominal target value because of the imprecise nature of implementing a circuit in which the value applies.

The term 'coupled' as used herein is defined as connected, although not necessarily directly and not necessarily mechanically. A device or structure that is 'configured' in a certain way is configured in at least that way, but may also be configured in ways that are not listed.

It will be appreciated that some embodiments may be comprised of one or more generic or specialized processors (or "processing devices") such as microprocessors, digital signal processors, customized processors and field programmable gate arrays (FPGAs) and unique stored program instructions (including both software and firmware) that control the one or more processors to implement, in conjunction with certain non-processor circuits, some, most, or all of the functions of the method and apparatus for synchronization in a digital mobile communication system as described herein. The non-processor circuits may include, but are not limited to, a radio receiver, a radio transmitter, signal drivers, clock circuits, power source circuits, and user input devices. As such, these functions may be interpreted as steps of a method to perform the synchronization in a digital mobile communication system as described herein. Alternatively, some or all functions could be implemented by a state machine that has no stored program instructions, or in one or more application specific integrated circuits (ASICs), in which each function or some combinations of certain of the functions are implemented as custom logic. Of course, a combination of the two approaches could be used. Both the state machine and ASIC are considered herein as a 'processing device' for purposes of the foregoing discussion and claim language.

Moreover, an embodiment including a memory can be implemented as a computer-readable storage element having computer readable code stored thereon for programming a computer (e.g., comprising a processing device) to perform a method as described and claimed herein. Examples of such computer-readable storage elements include, but are not limited to, a hard disk, a CD-ROM, an optical storage device, a magnetic storage device, a ROM (Read Only Memory), a PROM (Programmable Read Only Memory), an EPROM (Erasable Programmable Read Only Memory), an EEPROM (Electrically Erasable Programmable Read Only Memory) and a Flash memory.

Further, it is expected that one of ordinary skill, notwithstanding possibly significant effort and many design choices motivated by, for example, available time, current technology, and economic considerations, when guided by the concepts and principles disclosed herein will be readily capable of generating such software instructions and programs and ICs with minimal experimentation.

The Abstract of the Disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter may lie in less than all features of a single disclosed embodiment. Thus the following claims are hereby incorporated into the Detailed Description, with each claim standing on its own as a separately claimed subject matter.

## Claims

1. A linear RF transmitter (100) including:

   a forward path for receiving and processing, in an operational mode, an input baseband signal and for producing a modulated RF signal from the baseband signal, the forward path including a baseband signal combiner (109; 129) and an RF (radio frequency) power amplifier (123);
   a linearizing control loop including a coupling from an output of the RF power amplifier to an input of the combiner, wherein the control loop includes a feedback control path (105, 107) operable to deliver a baseband error control signal to the combiner;
a test signal generator (102), operable to apply to the combiner, in a closed loop level training mode, a test signal;
**characterised by**

the test signal comprising a voltage waveform ($V_{in}$) which increases with time in a non-linear manner approaching an asymptotic limit, such that, in response, an output signal produced by the combiner (109) is a voltage ($V_e$) which is constant over a period of time; and
the transmitter (100) further including a detector (110), operable to detect a rise in the voltage ($V_e$), following the period in which the voltage ($V_e$) is constant, indicating that operation of the RF power amplifier (123) has reached a 5 condition of compression.

2.  A transmitter (100) according to claim 1 wherein:

    the test signal generator (102) is operable to apply the test signal to a voltage level which causes, in response, operation of the RF power amplifier (123) to reach a condition of compression and the voltage $V_e$ to rise with time.

3.  A transmitter (100) according to claim 1 or claim 2, including:

    a low pass filter (113, 133) operable to provide a loop filter first pole of the control loop and to receive a baseband signal produced by the combiner, the voltage $V_e$ providing an input to the low pass filter in the level training mode.

4.  A transmitter (100) according to any preceding claim, wherein
    the forward path includes:

    (i) an I channel (101) for receiving and processing an I component of the baseband signal, the I channel including a first mixer (119) for upconverting the I component to produce an RF signal modulated by the I component; and
    (ii) a Q channel (103) for receiving and processing a Q component of the baseband signal, the Q channel including a second mixer (139) for upconverting the Q component to produce an RF signal modulated by the Q component; and

    the feedback control path (105, 107) includes:

    (i) an I feedback channel (105) for delivering an I component of the error control signal, the I feedback channel including a third mixer (143) for downconverting a sampled RF signal produced by the RF power amplifier (123) to produce the I component of the error control signal; and
    (ii) a Q feedback channel (107) for delivering a Q component of the error control signal, the Q feedback channel including a fourth mixer (147) for downconverting a sampled RF signal produced by the RF power amplifier (123) to produce the Q component of the error control signal.

5.  A method (400) of operation of a linear RF transmitter (100) including an RF power amplifier (123), the method including applying a test signal to a baseband signal combiner (109, 129) in a forward path of a linearizing control loop of the transmitter (100), in a closed loop level training mode;
    **characterised by**:

    the test signal comprising a voltage waveform ($V_{in}$) which increases with time in a non-linear manner approaching an asymptotic limit;
    developing in response a voltage ($V_e$) as an output of the combiner which is constant over a period of time;
    monitoring (405) the voltage ($V_e$) with time; and
    detecting (407) a rise in the voltage ($V_e$) following the period in which the voltage ($V_e$) is constant, indicating that operation of the RF power amplifier (123) has reached a condition of compression.

6.  A method (400) according to claim 5, further including:

    delivering, in response to the detection, a signal to a digital signal processor (102) indicating that operation of the RF power amplifier has reached a condition of compression.

7.  A method (400) according to claim 6' including:

    setting (409) by the digital signal processor (102) a baseband signal level using a time indicated by the delivered signal, wherein the test signal is produced by the digital signal processor and includes the digital signal processor using the time indicated by the delivered signal to identify a point in time on the test signal when the signal level is at a suitable level for selection.

8. A method (400) according to claim 7, which includes:

the digital signal processor (102) producing a baseband signal in an operational mode at a level selected in the level training mode.

9. A method according to any of preceding claims 5 to 8, wherein:

the voltage waveform $V_{in}$ varies with time $t$ according to an inverse exponential relationship given by

$$V_{in}(t) = k\beta A[1 - e^{-\frac{t}{\tau 1}}]$$ where $e$ represents an exponential, $\tau 1$ represents a time constant of a filter first pole of the control loop, $k$ represents a constant and $\beta A$ represents a loop gain of the control loop.

10. A method (400) according to any of preceding claims 5 to 9, which includes:

detecting a change in the voltage waveform $V_e$ by a detector comprising a voltage (110), which compares the voltage $V_e$ with a reference voltage.

11. A method (400) according to any of preceding claims 5 to 10, which is operated using a low pass filter in the linearizing control loop providing a loop filter first pole at a frequency of at least 1 kiloHertz.

12. A method (400) according to claim 11, wherein:

the loop filter first pole has a time constant $\tau 1$ of less than about 100 microseconds.

13. A method (400) according to claim 11, including applying the test signal for at least one from a group consisting of:

(i) a duration which is greater than three times the time constant $\tau 1$ of the first pole of the low pass filter;
(ii) a duration of between 100 microseconds and about 300 microseconds.

14. A method according to claim 13, including:

applying the test signal in the level training mode at regular intervals between periods when the transmitter (100) is operating in an operational mode.


**Patentansprüche**

1. Linearer RF-Sender (100), der umfasst:

einen Vorwärtspfad zum Empfangen und Verarbeiten, in einem Betriebsmodus, eines Eingangsbasisbandsignals und zum Erzeugen eines modulierten RF-Signals aus dem Basisbandsignal, wobei der Vorwärtspfad einen Basisbandkombinierer (109; 129) und einen RF (Funkfrequenz)-Leistungsverstärker (123) umfasst;
eine linearisierende Steuerschleife, die eine Kopplung von einem Ausgang des RF-Leistungsverstärkers zu einem Eingang des Kombinierers umfasst, wobei die Steuerschleife einen Rückkopplungssteuerpfad (105, 107) umfasst, der betreibbar ist, um ein Basisbandfehlersteuersignal an den Kombinierer zu liefern;
einen Testsignalgenerator (102), der betreibbar ist, um auf den Kombinierer, in einer Regelungspegelübungsbetriebsart, ein Testsignal anzuwenden;
**dadurch gekennzeichnet, dass**
das Testsignal eine Spannungswellenform ($v_{in}$) umfasst, die mit der Zeit in einer nicht linearen Weise zunimmt, und sich einem asymptotischen Grenzwert annähert, so dass in Reaktion darauf ein Ausgangssignal, das durch den Kombinierer (109) erzeugt wird, eine Spannung ($v_e$) ist, die über eine Zeitperiode konstant ist; und
der Sender (100) weiterhin einen Detektor (110) umfasst, der betreibbar ist, um im Anschluss an die Periode, in der die Spannung ($v_e$) konstant ist, eine Zunahme in der Spannung ($v_e$) zu erfassen, wobei angezeigt wird, dass ein Betrieb des RF-Leistungsverstärkers (123) eine Kompressionsbedingung erreicht hat.

2. Sender (100) gemäß Anspruch 1, wobei:

der Testsignalgenerator (102) betreibbar ist, um das Testsignal auf einen Spannungspegel anzuwenden, was in Reaktion darauf verursacht, dass ein Betrieb des RF-Leistungsverstärkers (123) eine Kompressionsbedingung erreicht und die Spannung $v_e$ mit der Zeit zunimmt.

3. Sender (100) gemäß Anspruch 1 oder Anspruch 2, der umfasst:

einen Tiefpassfilter (113, 133), der betreibbar ist, um einen ersten Schleifenfilterpol der Steuerschleife zur Verfügung zu stellen und ein Basisbandsignal zu empfangen, das durch den Kombinierer erzeugt wird, wobei die Spannung $v_e$ eine Eingabe in den Tiefpassfilter in der Pegelübungsbetriebsart zur Verfügung stellt.

4. Sender (100) gemäß einem der vorangehenden Ansprüche, wobei der Vorwärtspfad umfasst:

(i) einen I-Kanal (101) zum Empfangen und Verarbeiten einer I-Komponente des Basisbandsignals, wobei der I-Kanal einen ersten Mischer (119) zum Aufwärtswandeln der I-Komponente umfasst, um ein RF-Signal zu erzeugen, das durch die I-Komponente moduliert ist; und
(ii) einen Q-Kanal (103) zum Empfangen und Verarbeiten einer Q-Komponente des Basisbandsignals, wobei der Q-Kanal einen zweiten Mischer (139) zum Aufwärtswandeln der Q-Komponente umfasst, um ein RF-Signal zu erzeugen, das durch die Q-Komponente moduliert ist; und

der Rückkopplungssteuerpfad (105, 107) umfasst:

(i) einen I-Rückkopplungskanal (105) zum Liefern einer I-Komponente des Fehlersteuersignals, wobei der I-Rückkopplungskanal umfasst: einen dritten Mischer (143) zum Abwärtswandeln eines abgetasteten RF-Signals, das durch den RF-Leistungsverstärker (123) erzeugt wird, um die I-Komponente des Fehlersteuersignals zu erzeugen; und
(ii) einen Q-Rückkopplungskanal (107) zum Liefern einer Q-Komponente des Fehlersteuersignals, wobei der Q-Rückkopplungskanal umfasst: einen vierten Mischer (147) zum Abwärtswandeln eines abgetasteten RF-Signals, das durch den RF-Leistungsverstärker (123) erzeugt wird, um die Q-Komponente des Fehlersteuersignals zu erzeugen.

5. Verfahren (400) zum Betrieb eines linearen RF-Senders (100), der einen RF-Leistungsverstärker (123) umfasst, wobei das Verfahren umfasst:

Anwenden eines Testsignals auf einen Basisbandsignalkombinierer (109, 129) in einem Vorwärtspfad einer linearisierenden Steuerschleife des Senders (100) in einer Regelungspegelübungsbetriebsart;
**gekennzeichnet durch**:

Umfassen des Testsignals einer Spannungswellenform ($v_{in}$), die mit der Zeit in einer nicht-linearen Weise zunimmt, und sich einem asymptotischen Grenzwert annähert;
in Reaktion darauf, Entwickeln einer Spannung ($v_e$) als eine Ausgabe des Kombinierers, die über eine Zeitperiode konstant ist;
Überwachen (405) der Spannung ($v_e$) über die Zeit; und
Erfassen (407) einer Zunahme der Spannung ($v_e$) im Anschluss an die Periode, in der die Spannung ($v_e$) konstant ist, wobei angezeigt wird, dass ein Betrieb des RF-Leistungsverstärkers (123) eine Kompressionsbedingung erreicht hat.

6. Verfahren (400) gemäß Anspruch 5, das weiterhin umfasst:

in Reaktion auf das Erfassen, Liefern eines Signals an einen digitalen Signalprozessor (102), das anzeigt, dass ein Betrieb des RF-Leistungsverstärkers eine Kompressionsbedingung erreicht hat.

7. Verfahren (400) gemäß Anspruch 6, das umfasst:

Setzen (409), durch den digitalen Signalprozessor (102), eines Basisbandsignalpegels unter Verwendung einer durch das gelieferte Signal angezeigten Zeit, wobei das Testsignal durch den digitalen Signalprozessor erzeugt wird und umfasst, dass der digitale Signalprozessor die durch das gelieferte Signal angezeigte Zeit verwendet, um einen Zeitpunkt auf dem Testsignal zu identifizieren, zu dem sich der Signalpegel auf einem geeigneten Pegel für eine Auswahl befindet.

**8.** Verfahren (400) gemäß Anspruch 7, das umfasst:

dass der digitale Signalprozessor (102) ein Basisbandsignal in einem Betriebsmodus bei einem Pegel erzeugt, der in der Pegelübungsbetriebsart ausgewählt wird.

**9.** Verfahren gemäß einem der vorangehenden Ansprüche 5 bis 8, wobei:

die Spannungswellenform $v_{in}$ mit der Zeit $t$ gemäß einer inversen exponentiellen Beziehung variiert, gegeben durch

$$v_{in}(t) = k\beta A \left[ 1 - e^{\frac{t}{\tau 1}} \right]$$

wobei $e$ ein Exponential darstellt, $\tau 1$ eine Zeitkonstante eines ersten Filterpols der Steuerschleife darstellt, $k$ eine Konstante darstellt und $\beta A$ eine Schleifenverstärkung der Steuerschleife darstellt.

**10.** Verfahren (400) gemäß einem der vorangehenden Ansprüche 5 bis 9, das umfasst:

Erfassen einer Änderung in der Spannungswellenform $v_e$ durch einen Detektor, der eine Spannung (110) umfasst, der die Spannung $v_e$ mit einer Referenzspannung vergleicht.

**11.** Verfahren (400) gemäß einem der vorangehenden Ansprüche 5 bis 10, das unter Verwendung eines Tiefpassfilters in der linearisierenden Steuerschleife betrieben wird, wobei ein erster Schleifenfilterpol bei einer Frequenz von mindestens 1 Kilohertz zur Verfügung gestellt wird.

**12.** Verfahren (400) gemäß Anspruch 11, wobei:

der erste Schleifenfilterpol über eine Zeitkonstante $\tau 1$ von weniger als ungefähr 100 Mikrosekunden verfügt.

**13.** Verfahren (400) gemäß Anspruch 11, das umfasst:

Anwenden des Testsignals für:

(i) eine Dauer, die länger als die dreifache Zeitkonstante $\tau 1$ des ersten Pols des Tiefpassfilters ist; und/oder
(ii) eine Dauer von zwischen 100 Mikrosekunden und ungefähr 300 Mikrosekunden.

**14.** Verfahren gemäß Anspruch 13, das umfasst:

Anwenden des Testsignals in der Pegelübungsbetriebsart bei regelmäßigen Intervallen zwischen Perioden, in denen der Sender (100) in einem Betriebsmodus arbeitet.

**Revendications**

**1.** Emetteur RF linéaire (100) comportant :

une voie aller pour la réception et le traitement, dans un mode opérationnel, d'un signal d'entrée en bande de base, et pour la production d'un signal RF modulé à partir du signal en bande de base, la voie aller comportant un combineur de signal en bande de base (109 ; 129) et un amplificateur de puissance RF (radiofréquence) (123) ;

une boucle de commande de linéarisation comportant un couplage d'une sortie de l'amplificateur de puissance RF à une entrée du combineur, laquelle boucle de commande comporte une voie de commande à rétroaction (105, 107) apte à délivrer au combineur un signal de commande d'erreur en bande de base ;

un générateur de signal de test (102), apte à appliquer au combineur, dans un mode apprentissage de niveau à boucle fermée, un signal de test ;

**caractérisé par**

le signal test comprenant une forme d'onde de tension $(V_{in})$ qui augmente avec le temps d'une manière non linéaire en approchant une limite asymptotique, de telle sorte que, en réponse, un signal de sortie produit par le combineur (109) soit une tension $(V_e)$ qui est constante sur une période de temps ; et

l'émetteur (100) comportant en outre un détecteur (110), apte à détecter une augmentation de la tension $(V_e)$, après la période pendant laquelle la tension $(V_e)$ est constante, indiquant que le fonctionnement de l'amplificateur de puissance RF (123) a atteint une condition de compression.

2. Emetteur (100) selon la revendication 1, dans lequel :

le générateur de signal de test (102) est apte à appliquer le signal de test à un niveau de tension qui amène, en réponse, le fonctionnement de l'amplificateur de puissance RF (123) à atteindre une condition de compression et la tension $V_e$ à augmenter avec le temps.

3. Emetteur (100) selon la revendication 1 ou la revendication 2, comportant :

un filtre passe-bas (113, 133) apte à fournir un premier pôle de filtre de boucle de la boucle de commande et à recevoir un signal en bande de base produit par le combineur, la tension $V_e$ constituant une entrée du filtre passe-bas au mode apprentissage de niveau.

4. Emetteur (100) selon l'une quelconque des revendications précédentes, dans lequel :

la voie aller comporte :

(i) un canal I (101) pour la réception et le traitement d'une composante I du signal en bande de base, le canal I comportant un premier mélangeur (119) pour l'élévation en fréquence de la composante I afin de produire un signal RF modulé par la composante I ; et

(ii) un canal Q (103) pour la réception et le traitement d'une composante Q du signal en bande de base, le canal Q comportant un deuxième mélangeur (139) pour l'élévation en fréquence de la composante Q afin de produire un signal RF modulé par la composante Q ; et

la voie de commande à rétroaction (105, 107) comporte :

(i) un canal de rétroaction I (105) pour la délivrance d'une composante I du signal de commande d'erreur, le canal de rétroaction I comportant un troisième mélangeur (143) pour l'abaissement en fréquence d'un signal RF échantillonné, produit par l'amplificateur de puissance RF (123), afin de produire la composante I du signal de commande d'erreur ; et

(ii) un canal de rétroaction Q (107) pour la délivrance d'une composante Q du signal de commande d'erreur, le canal de rétroaction Q comportant un quatrième mélangeur (147) pour l'abaissement en fréquence d'un signal RF échantillonné, produit par l'amplificateur de puissance RF (123), afin de produire la composante Q du signal de commande d'erreur.

5. Procédé (400) de fonctionnement d'un émetteur RF linéaire (100) comportant un amplificateur de puissance RF (123), le procédé comportant l'application d'un signal de test à un combineur de signal en bande de base (109, 129) sur une voie aller d'une boucle de commande de linéarisation de l'émetteur (100), dans un mode d'apprentissage de niveau à boucle fermée ;

**caractérisé par :**

**le fait que** le signal de test comprend une forme d'onde de tension $(V_{in})$ qui augmente avec le temps d'une manière non linéaire en approchant une limite asymptotique ;

le développement, en réponse, d'une tension $(V_e)$ en sortie du combineur, qui est constante sur une période de temps ;

la surveillance (405) de la tension ($V_e$) dans le temps ; et

la détection (407) d'une augmentation de la tension ($V_e$) après la période pendant laquelle la tension ($V_e$) est constante, indiquant que le fonctionnement de l'amplificateur de puissance RF (123) a atteint une condition de compression.

**6.** Procédé (400) selon la revendication 5, comportant en outre :

la délivrance, en réponse à la détection, d'un signal à un processeur de signaux numériques (102) indiquant que le fonctionnement de l'amplificateur de puissance RF a atteint une condition de compression.

**7.** Procédé (400) selon la revendication 6, comportant :

le réglage (409) par le processeur de signaux numériques (102) d'un niveau de signal en bande de base à l'aide d'un temps indiqué par le signal délivré, dans lequel le signal de test est produit par le processeur de signaux numériques et comporte le fait que le processeur de signaux numériques utilise le temps indiqué par le signal délivré pour identifier un point dans le temps sur le signal de test où le niveau du signal se trouve à un niveau approprié pour être sélectionné.

**8.** Procédé (400) selon la revendication 7, qui comporte :

le fait que le processeur de signaux numériques (102) produit, dans un mode opérationnel, un signal en bande de base à un niveau sélectionné au mode apprentissage de niveau.

**9.** Procédé selon l'une quelconque des revendications précédentes 5 à 8, dans lequel :

la forme d'onde de tension $V_{in}$ varie avec le temps $t$ selon une relation exponentielle inverse donnée par :

$$V_{in}(t) = k\beta A \left[ 1 - e^{-\frac{t}{\tau 1}} \right],$$ où $e$ représente une exponentielle, $\tau 1$ représente une constante de temps d'un premier pôle de filtre de la boucle de commande, $k$ représente une constante et $\beta A$ représente un gain de boucle de la boucle de commande.

**10.** Procédé (400) selon l'une quelconque des revendications précédentes 5 à 9, qui comporte :

la détection d'un changement de la forme d'onde de tension $V_e$ par un détecteur comprenant une tension (110), qui compare la tension $V_e$ à une tension de référence.

**11.** Procédé (400) selon l'une quelconque des revendications précédentes 5 à 10, qui est mis en oeuvre à l'aide d'un filtre passe bas dans la boucle de commande de linéarisation, fournissant un premier pôle de filtre de boucle à une fréquence d'au moins 1 kiloHertz.

**12.** Procédé (400) selon la revendication 11, dans lequel :

le premier pôle de filtre de boucle a une constante de temps $\tau 1$ de moins d'environ 100 microsecondes.

**13.** Procédé (400) selon la revendication 11, comportant :

l'application du signal de test pendant au moins l'une d'un groupe constitué de :

(i) une durée qui est supérieure à trois fois la constante de temps $\tau 1$ du premier pôle du filtre passe-bas ;
(ii) une durée comprise entre 100 microsecondes et environ 300 microsecondes.

**14.** Procédé selon la revendication 13, comportant :

l'application du signal de test au mode apprentissage de niveau, à intervalles réguliers, entre des périodes pendant lesquelles l'émetteur (100) fonctionne dans un mode opérationnel.

FIG. 1

_200_

FIG. 2

_300_

FIG. 3

_400_

401

┌─────────────────────────────────────────────┐
│ SUSPEND NORMAL OPERATIONAL MODE TO            │
│ BEGIN CLOSED LOOP LEVEL TRAINING MODE         │
└─────────────────────────────────────────────┘

403

┌─────────────────────────────────────────────┐
│ APPLY TO LOOP COMBINER INVERSE               │
│ EXPONENTIAL TEST SIGNAL $V_{in}$              │
└─────────────────────────────────────────────┘

405

┌─────────────────────────────────────────────┐
│ MONITOR VOLTAGE $V_e$ AT THE COMBINER OUTPUT │
└─────────────────────────────────────────────┘

407

┌─────────────────────────────────────────────┐
│ DETECT RFPA COMPRESSION FROM INCREASE        │
│ OF $V_e$ AND DELIVER AN INDICATION SIGNAL TO │
│ DSP                                           │
└─────────────────────────────────────────────┘

409

┌─────────────────────────────────────────────┐
│ SET SIGNAL LEVEL BY DSP                       │
└─────────────────────────────────────────────┘

411

┌─────────────────────────────────────────────┐
│ RESUME NORMAL OPERATIONAL MODE AND           │
│ USE SET SIGNAL LEVEL IN THAT MODE            │
└─────────────────────────────────────────────┘

*FIG. 4*

**EP 2 258 045 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2287371 A, Motorola